# EUROPÄISCHE PATENTANMELDUNG

(11) **EP 0 942 290 A1**
(43) Veröffentlichungstag der Anmeldung: **15.09.1999**
(21) Anmeldenummer: 98104559.4
(22) Anmeldetag: 13.03.1998
(51) Int. Cl.: G01R 22/00, H02J 13/00

(54) **Gerät mit kundenneutralen Bestandteilen, mindestens einem kundenspezifischen Bestandteil und mindestens einem Prozessor**

(71) Anmelder: Electrowatt Technology Innovation AG, 6301 Zug (CH)
(72) Erfinder: Rohrer, Alois, 6340 Baar (CH); Janssen, Peter, 6313 Menzingen (CH); Loder, Christian, 6048 Horw (CH)

(57) **Zusammenfassung**

Das Gerät enthält kundenneutrale Bestandteile, mindestens ein kundenspezifisches Bestandteil (1, 2) und einen Prozessor, wobei der letztere und ein Teil der Bestandteile ein Teilgerät bilden, welches mittels kundenneutraler Bestandteile aufgebaut ist. Das Gerät weist ausserdem eine Anordnung auf zum kundenneutralen parametrieren des Teilgerätes mit Hilfe einer Geräte-Software zwecks Bildung eines hard- und softwaremässig kundenneutralen Teilgerätes (7). Das letztere sowie mindestens ein weiteres, sich ausserhalb des Teilgerätes befindliches kundenspezifisches oder kundenneutrales Bestandteil (1, 2, 4) weist Mittel auf zum Montieren des kundenspezifischen Bestandteils (1, 2) auf das kundenneutrale Teilgerät (7) unter Aufrechterhaltung von dessen Aufbau und Parametrierung zwecks Bildung eines kundenspezifischen Gerätes. Das kundenneutrale Teilgerät (7) wird kundenspezifisch parametriert mit Hilfe der Geräte-Software. Die Erfindung ermöglicht unter Berücksichtigung auftragsspezifischer Kundenwünsche eine narrensichere, rationelle, flexible, einfache und kostengünstige Endmontage und Lagerhaltung des Gerätes mit minimalen Logistikproblemen.

## Beschreibung

Die Erfindung bezieht sich auf ein Gerät mit kundenneutralen Bestandteilen, mindestens einem kundenspezifischen Bestandteil und mindestens einem Prozessor gemäss dem Oberbegriff des Anspruchs 1.

Das Gerät ist vorzugsweise ein Elektrizitätszähler, ein Tarifgerät, ein Rundsteuerempfänger, ein dazugehöriges Hilfsgerät oder eine Kombination eines Elektrizitätszählers mit einem Tarifgerät und/oder einem Rundsteuerempfänger. Der Rundsteuerempfänger kann dabei jeweils ein klassischer Rundsteuerempfänger oder ein Funk-Rundsteuerempfänger sein. Bei klassischen Rundsteuerempfängern werden bekanntlich die zu empfangenden Informationen über ein Energieversorgungsnetz übertragen. Elektrizitätszähler sind bekanntlich kalibrierte und geeichte Energie-Messgeräte.

Ein Gerät der eingangs genannten Art, nämlich ein Elektrizitätszähler mit Teilgeräten, ist aus der EP 0 715 171 A2 bekannt.

Kundenspezifische Geräte, die auftragsspezifisch ausgebildet sind, bestehen in der Regel aus kundenneutralen Bestandteilen und mindestens einem kundenspezifischen Bestandteil. Kundenspezifische Bestandteile sind z. B ein Zifferblatt und/oder eine Klemmenleiste, bei denen jeweils in der Regel mindestens eine Beschriftung bzw. Prägung kundenspezifisch ausgebildet ist. Die Klemmenleiste kann ausserdem je nach Kunde eine unterschiedliche Anzahl und/oder Gestalt von Klemmen und/oder Schrauben aufweisen. Auch können die Gestalt sowie Ausbildung der Vorrichtung, in der die Klemmen und Schrauben der Klemmenleiste untergebracht sind, kundenspezifisch sein. Kundenspezifische Geräte, die mit einem Computer, vorzugsweise einem Mikrocomputer, ausgerüstet sind, benötigen ausserdem eine teils kundenneutrale und eine teils kundenspezifische Software, wobei die letztere einer kundenspezifischen Parametrierung und/oder Konfiguration des betreffenden Gerätes dient. Dabei müssen die jeweilige Konfiguration und Parametrierung mit Angaben und Ausführung der kundenspezifischen Bestandteile des Gerätes, insbesondere mit deren Beschriftung, übereinstimmen. Dies kann zu Logistikproblemen führen, da in einer Produktion zusammengehörige, zu einem bestimmten Kunde oder Auftrag gehörende Hardwarebestandteile und Konfigurations/Parametrier-Daten in der Regel zu unterschiedlichen Zeiten, an unterschiedlichen Orten und auf getrennten Wegen bereitgestellt bzw. dem Gerät zugeführt werden. Mindestens Endmontage, Lagerhaltung und Logistik solcher kundenspezifischen Geräte und deren Bestandteile werden demnach erschwert, kompliziert, unflexibel und unübersichtlich. Ausserdem ist die Gefahr gross, dass nicht zusammengehörige kundenspezifische Bestandteile und Software in einem gleichen Gerät installiert werden, was zu Leerlauf, Reparaturen, unnötigen Kosten, Kundenreklamationen und Image-Verlusten führen kann.

Der Erfindung liegt die Aufgabe zugrunde, ein Gerät der eingangs genannten Art so zu realisieren, dass unter Berücksichtigung auftrags- und/oder kundenspezifischer Wünsche der Kunden die obenerwähnten Schwierigkeiten vermieden werden und eine rationelle, flexible, einfache und kostengünstige Endmontage sowie Lagerhaltung von gegebenenfalls kalibrierten Geräten mit minimalen Logistikproblemen möglich ist. Die Erfindung hat den grossen Vorteil, dass es möglich ist, aus einer kundenneutralen Geräte-Hardware, die ein kundenneutrales Teilgerät bilden, durch eine softwaremässige kundenspezifische Parametrierung und/oder Konfiguration des Teilgerätes sowie ein nachträgliches Hinzufügen eines oder mehrerer weniger kundenspezifischer Hardware-Bestandteile das gewünschte Gerät narrensicher kundenspezifisch zu erstellen.

Die genannte Aufgabe wird erfindungsgemäss durch die im Kennzeichen des Anspruchs 1 angegebenen Merkmale gelöst. Vorteilhafte Ausgestaltungen der Erfindung ergeben sich aus den abhängigen Ansprüchen.

Ein Ausführungsbeispiel der Erfindung ist in der Zeichnung dargestellt und wird im folgenden näher beschrieben.

Es zeigen:
- Fig. 1: eine Explosionszeichnung eines erfindungsgemässen Gerätes,
- Fig. 2: eine erste Variante eines kundenspezifischen Bestandteils mit einer Chip-Karte und
- Fig. 3: eine zweite Variante eines kundenspezifischen Bestandteils mit einer Chip-Karte.

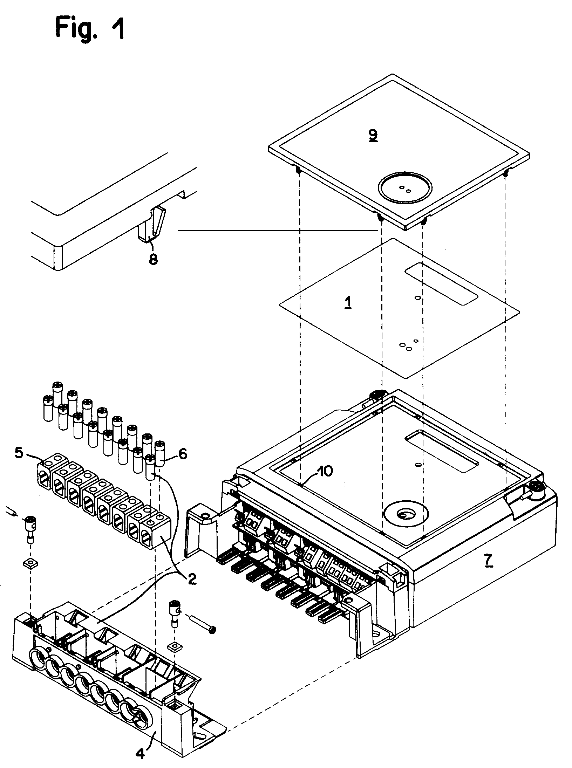

Das erfindungsgemässe Gerät enthält kundenneutrale Bestandteile, mindestens ein kundenspezifisches Bestandteil und mindestens einen Prozessor, wobei der letztere und ein Teil der Bestandteile ein Teilgerät bilden (siehe Fig. 1). Das kundenspezifische Bestandteil ist z. B. ein Zifferblatt 1 und/oder eine Klemmenleiste 2. Die Klemmenleiste 2 besteht aus einer Vorrichtung 4, in der Klemmen 5 und Schrauben 6 angeordnet sind. Die Vorrichtung 4 und/oder die Klemmen 5 und/oder die Schrauben 6 sind kundenspezifisch. Es können jedoch auch noch andere, nicht genannte kundenspezifische Bestandteile im Gerät vorhanden sein. Das Teilgerät ist mittels kundenneutraler Bestandteile kundenneutral aufgebaut. Der Prozessor ist vorzugsweise ein Mikroprozessor und besitzt eine ihm zugehörige Geräte-Software. Es weist ausserdem eine Anordnung aufzum kundenneutralen parametrieren und/oder einstellen und/oder abgegleichen und/oder kalibrieren des Teilgerätes mit Hilfe der Geräte-Software zwecks Bildung eines hard- und softwaremässig kundenneutralen Teilgerätes 7. Das letztere wird unabhängig von konkreten Kundenaufträgen im voraus geprüft, kalibriert (falls das Gerät ein Elektrititätszähler ist) und schliesslich kundenneutral auf Lager gelegt. Die lagerhaltung der Teilgeräte 7 ist dadurch bedingt einfach und kostengünstig.

Die kundenspezifischen Bestandteile 1 und/oder 2 gehören zu den letzten, auf oder in das kundenneutrale Teilgerät 7 montierten Bestandteilen. Sie werden erst nachträglich, z. B. kurz vor Auslieferung an die Kunden, auf das Teilgerät 7 montiert und zwar jeweils so, dass bei kalibrierten Teilgeräten 7 keine erneute Kalibrierung erforderlich ist. Zwecks Bildung eines kundenspezifisch aufgebauten Gerätes weisen das kundenneutrale Teilgerät 7 sowie mindestens ein weiteres, sich ausserhalb des Teilgerätes 7 befindliches kundenspezifisches oder kundenneutrales Bestandteil Mittel auf zum Montieren des kundenspezifischen Bestandteils 1 und/oder 2 auf oder in das kundenneutrale Teilgerät 7 und zwar jeweils unter Aufrechterhaltung von dessen Aufbau, Parametrierung, Einstellung, Abgleich und Kalibration. Das Gerät besitzt schliesslich noch eine Anordnung zum kundenspezifischen parametrieren und/oder einstellen und/oder abgegleichen und/oder kalibrieren des kunderneutralen Teilgerätes 7 oder des kundenspezifisch aufgebauten Gerätes mit Hilfe der Geräte-Software. Bei einem Entfernen und/oder Tausch mindestens eines Teils der derart montierten kundenspezifischen Bestandteile ist vorzugsweise ein Indiz vorhanden, an dem das Entfernen beziehungsweise der Tausch erkennbar ist und zwar bevorzugt unwiderruflich. Das Indiz ist in der Regel eine Beschädigung mindestens eines Bestandteils des Gerätes. Z. B. besitzt das betreffende Bestandteil eine Sollbruchstelle, deren mechanische Festigkeit schwächer ist als diejenige benachbarter Teile. In diesem Fall ist die Beschädigung z. B. ein Bruch dieser Sollbruchstelle. Zur Montage des kundenspezifischen Bestandteils 1 kann jedoch auch ein besonders starker Kleber verwendet werden, so dass bei einem versuchten Tausch des betreffenden Bestandteils die Beschädigung eines benachbarten Geräte-Bestandteils viel wahrscheinlicher ist als ein unerkannter Austausch des kundenspezifischen Bestandteils. Das Mittel zum Montieren des kundenspezifischen Bestandteils 1 und/oder 2 auf oder in das kundenneutrale Teilgerät 7 ist einer Variante ein Aufschnapp-Mechanismus 8 des kundenspezifischen Bestandteils und/oder eines kundenneutralen Bestandteils 9 (siehe Fig. 1). Der Aufschnapp-Mechanismus 8 ist dabei z. B. derart ausgebildet, dass er in Montagerichtung durch eine Montage-Öffnung 10 des Teilgerätes 7 steckbar ist, jedoch in umkehrter Richtung von aussen nur unter Beschädigung des Aufschnapp-Mechanismuses 8 und/oder eines Bestandteils des Gerätes wieder entfernbar ist. Das kundenspezifische Bestandteil 1 oder 2 ist entweder mittelbar mit Hilfe des kundenneutralen Bestandteils 9 bzw. 4, oder unmittelbar aufoder in das kundenneutrale Teilgerät 7 montierbar. Im ersteren Fall ist das kundenneutrale Bestandteil 9 oder 4, mit dessen Hilfe das kundenspezifische Bestandteil 1 oder 2 auf oder in das kundenneutrale Teilgerät 7 montierbar ist, z. B. eine Abdeckung 9 oder die Vorrichtung 4 zur Aufnahme kundenspezifischer und/oder kundenneutraler Bestandteile, wie z. B. die Klemmen 5 und/oder die Schrauben 6. Die Abdeckung 9 besteht vorzugsweise aus transparentem Kunststoff. Die Vorrichtung 4 kann jedoch auch selber ein kundenspezifisches Bestandteil sein, wenn sie z. B. unmittelbar mit kundenspezifischen Angaben versehen ist oder eine kundenspezifische Gestalt aufweist. In der Regel sind Anzahl und/oder Gestalt der in der Vorrichtung 4 enthaltenen Bestandteile, also der Klemmen 5 und/oder der Schrauben 6, kundenspezifische Merkmale einer bestückten Vorrichtung 4. Die Vorrichtung 4 und/oder die in ihr enthaltenen Klemmen 5 sind z. B. unmittelbar durch direktes Bedrucken oder mittelbar mit kundenspezifischen Angaben versehen. Im letzteren Fall befinden sich die kundenspezifischen Angaben z. B. auf einem oder mehreren Etiquetten und/oder Aufklebern, welche ihrerseits z. B. auf die Vorrichtung 4 angeordnet sind. Die Vorrichtung 4 mit den in ihr enthaltenen Bestandteilen 5 und 6 bilden zusammen, wie bereits erwähnt, die kundenspezifische Klemmenleiste 2. Das kundenspezifische Bestandteil 1 kann die Gestalt eines Blattes, einer Platte, einer Karte oder einer Folie besitzen. Es ist dann vorzugsweise mit kundenspezifischen Angaben versehen, die nach einer Montage des kundenspezifischen Bestandteils 1 von aussen sichtbar sind und in der Regel die Gestalt einer Schrift und/oder einer Graphik und/oder eines Codes, z. B. eines sogenannten Bar-Codes, besitzen. In allen aufgelisteten Fällen kann ein Aufdruck der Schrift und/oder der Graphik und/oder des Codes ein mittels Spritzens, eines Laserbrennens, eines Stempels, eines Thermotransfer-Druckers, eines Tintenstrahls oder eines Laserdruckers erzeugter Aufdruck sein und unterschiedliche Farben aufweisen.

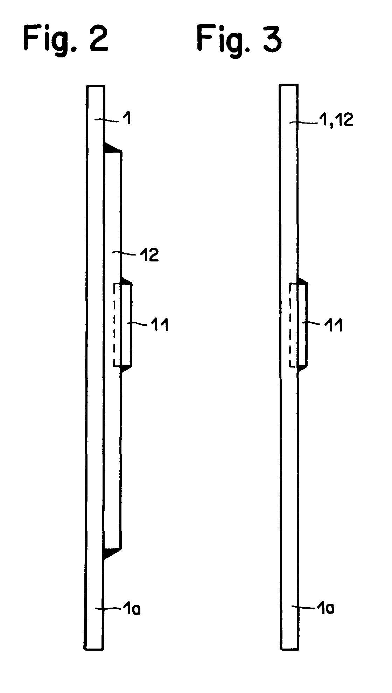

Das kundenspezifische Bestandteil 1 weist in einer bevorzugt verwendeten Variante mindestens einen Speicher oder Informationsträger auf, in dem maschinell lesbare kundenspezifische Daten gespeichert sind. Zur Konfiguration und Parametrierung des Teilgerätes 7 weist dann das letztere eine Vorrichtung auf zur maschinellen Übernahme und Speicherung der im Speicher oder auf dem Informationsträger gespeicherten kundenspezifischen Daten in das Teilgerät 7 und zwar nach einer Montage des kundenspezifischen Bestandteils 1 auf dem Teilgerät 7. Die Geräte-Software ist z. B. so programmiert, dass - nach einer Montage des kundenspezifischen Bestandteils 1 - die auf dem letzteren gespeicherten kundenspezifischen Daten automatisch in das Teilgerät 7 übernommen und dort gespeichert werden. Das Teilgerät 7 weist bevorzugt eine Fehleranzeige auf, so dass nach der Montage des kundenspezifischen Bestandteils 1 und der Übernahme der gespeicherten kundenspezifischen Daten in das Teilgerät 7, im Gerät eine Fehlermeldung vorhanden ist bei Existenz einer Widersprüchlichkeit der kundenspezifischen Daten mit einer im Gerät vorhandenen Hard- und/oder Firmware. Vorzugsweise ist im Gerät auch eine Anordnung vorhanden zur Erzeugung sichtbarer kundenspezifischer Angaben auf das kundenspezifische Bestandteil 1 mittels der im Speicher oder aufdem Informationsträger des kundenspezifischen Bestandteils 1 gespeicherten kundenspezifischen Daten. Der Speicher beziehungsweise der Informationsträger des kundenspezifischen Bestandteils 1 ist vorzugsweise auf einer Rückseite 1a oder Vorderseite des Bestandteils 1 angeordnet. Der Speicher des kundenspezifischen Bestandteils ist dabei bevorzugt in einem Chip 11 enthalten, der ein Teil einer Chip-Karte 12 ist (siehe Fig. 2 und Fig. 3). Entweder ist dann die Chip-Karte 12 auf einer Seite, z. B. 1a, des kundenspezifischen Bestandteils 1 montiert, z. B. geklebt oder vergossen angeordnet (siehe Fig. 2), oder das kundenspezifische Bestandteil 1 ist selber als Chip-Karte ausgebildet und der Chip 11 ist unmittelbar auf einer Seite, z. B. 1a, des kundenspezifischen Bestandteils 1 montiert.

## Patentansprüche

1. Gerät mit kundenneutralen Bestandteilen, mindestens einem kundenspezifischen Bestandteil (1, 2) und mindestens einem Prozessor, wobei der letztere und ein Teil der Bestandteile ein Teilgerät bilden,
**dadurch gekennzeichnet,**
- dass das Teilgerät mittels kundenneutraler Bestandteile kundenneutral aufgebaut ist und das Gerät eine Anordnung aufweist zum kundenneutralen parametrieren und/oder einstellen und/oder abgegleichen und/oder kalibrieren des Teilgerätes mit Hilfe einer Geräte-Software zwecks Bildung eines hard- und softwaremässig kundenneutralen Teilgerätes (7),
- dass das kundenneutrale Teilgerät (7) sowie mindestens ein weiteres, sich ausserhalb des Teilgerätes befindliches kundenspezifisches oder kundenneutrales Bestandteil (1, 2, 4) Mittel aufweisen zum Montieren des kundenspezifischen Bestandteils (1, 2) auf oder in das kundenneutrale Teilgerät (7) unter Aufrechterhaltung von dessen Aufbau, Parametrierung, Einstellung, Abgleich und Kalibration, zwecks Bildung eines kundenspezifisch aufgebauten Gerätes und
- dass das Gerät eine Anordnung besitzt zum kundenspezifischen parametrieren und/oder einstellen und/oder abgegleichen und/oder kalibrieren des kundenneutralen Teilgerätes (7) oder des kundenspezifisch aufgebauten Gerätes mit Hilfe der Geräte-Software.

2. Gerät nach Anspruch 1, dadurch gekennzeichnet, dass bei einem Entfernen und/oder Tausch des derart montierten kundenspezifischen Bestandteils (1; 2) ein Indiz vorhanden ist, an dem das Entfernen beziehungsweise der Tausch erkennbar ist.

3. Gerät nach Anspruch 2, dadurch gekennzeichnet, dass das Indiz eine Beschädigung mindestens eines Bestandteils des Gerätes ist.

4. Gerät nach Anspruch 3, dadurch gekennzeichnet, dass die Beschädigung ein Bruch einer Sollbruchstelle ist.

5. Gerät nach einem der Ansprüche 1 bis 4, dadurch gekennzeichnet, dass das Mittel zum Montieren des kundenspezifischen Bestandteils (1, 2) auf oder in das kundenneutrale Teilgerät (7) ein Aufschnapp-Mechanismus (8) des kundenspezifischen Bestandteils und/oder eines kundenneutralen Bestandteils (9) ist, der derart ausgebildet ist, dass er in Montagerichtung durch eine Montage-Öffnung (10) des Teilgerätes (7) steckbar ist, jedoch in umkehrter Richtung von aussen nur unter Beschädigung des Aufschnapp-Mechanismuses (8) und/oder eines Bestandteils des Gerätes wieder entfernbar ist.

6. Gerät nach einem der Ansprüche 1 bis 5, dadurch gekennzeichnet, dass das kundenspezifische Bestandteil (1, 2) unmittelbar aufoder in das kundenneutrale Teilgerät (7) montierbar ist.

7. Gerät nach einem der Ansprüche 1 bis 5, dadurch gekennzeichnet, dass das kundenspezifische Bestandteil (1, 2) mittelbar mit Hilfe eines der kundenneutralen Bestandteile (9, 4) auf oder in das kundenneutrale Teilgerät (7) montierbar ist.

8. Gerät nach Anspruch 7, dadurch gekennzeichnet, dass das kundenneutrale Bestandteil (9), mit dessen Hilfe das kundenspezifische Bestandteil (1) auf oder in das kundenneutrale Teilgerät (7) montierbar ist, eine Abdeckung ist.

9. Gerät nach einem der Ansprüche 1 bis 8, dadurch gekennzeichnet, dass das kundenspezifische Bestandteil (1) die Gestalt eines Blattes, einer Platte, einer Karte oder einer Folie besitzt.

10. Gerät nach einem der Ansprüche 1 bis 9, dadurch gekennzeichnet, dass das kundenspezifische Bestandteil (1) mit kundenspezifischen Angaben versehen ist, die nach einer Montage des kundenspezifischen Bestandteils (1) von aussen sichtbar sind.

11. Gerät nach Anspruch 10, dadurch gekennzeichnet, dass die kundenspezifischen Angaben die Gestalt einer Schrift und/oder einer Graphik und/oder eines Codes besitzen.

12. Gerät nach Anspruch 11, dadurch gekennzeichnet, dass ein Aufdruck der Schrift und/oder der Graphik und/oder des Codes ein mittels eines Laserdruckers oder Thermotransfer-Druckers erzeugter Aufdruck ist.

13. Gerät nach einem der Ansprüche 1 bis 12, dadurch gekennzeichnet, dass das kundenspezifische Bestandteil (1) ein Zifferblatt ist.

14. Gerät nach Anspruch 6 oder 7, dadurch gekennzeichnet, dass das kundenspezifische Bestandteil beziehungsweise das kundenneutrale Bestandteil, mit dessen Hilfe das kundenspezifische Bestandteil (2) auf oder in das kundenneutrale Teilgerät (7) montierbar ist, eine Vorrichtung (4) ist zur Aufnahme kundenspezifischer und/oder kundenneutraler Bestandteile (5, 6).

15. Gerät nach Anspruch 14, dadurch gekennzeichnet, dass Anzahl und/oder Gestalt der in der Vorrichtung (4) enthaltenen Bestandteile (5, 6) kundenspezifisch sind.

16. Gerät nach Anspruch 14 oder 15, dadurch gekennzeichnet, dass die in der Vorrichtung (4) enthaltenen Bestandteile (5, 6) Klemmen und/oder Schrauben sind.

17. Gerät nach einem der Ansprüche 14 bis 16, dadurch gekennzeichnet, dass die Vorrichtung (4) und/oder die in ihr enthaltenen Klemmen (5) unmittelbar oder mittelbar mit kundenspezifischen Angaben versehen sind.

18. Gerät nach Anspruch 17, dadurch gekennzeichnet, dass die kundenspezifischen Angaben sich auf einem oder mehreren Etiquetten und/oder Aufklebern befinden.

19. Gerät nach einem der Ansprüche 14 bis 18, dadurch gekennzeichnet, dass die Vorrichtung (4) selber ein kundenspezifisches Bestandteil ist.

20. Gerät nach einem der Ansprüche 14 bis 19, dadurch gekennzeichnet, dass die Vorrichtung (4) mit den in ihr enthaltenen Bestandteilen (5, 6) zusammen eine kundenspezifische Klemmenleiste bilden.

21. Gerät nach einem der Ansprüche 1 bis 20, dadurch gekennzeichnet, dass das kundenspezifische Bestandteil (1) mindestens einen Speicher oder Informationsträger aufweist, in dem maschinell lesbare kundenspezifische Daten gespeichert sind.

22. Gerät nach Anspruch 21, dadurch gekennzeichnet, dass zur Parametrierung des Teilgerätes (7) das letztere eine Vorrichtung aufweist zur maschinellen Übernahme und Speicherung in das Teilgerät (7) der im Speicher oder aufdem Informationsträger des kundenspezifischen Bestandteils (1) gespeicherten kundenspezifischen Daten nach einer Montage des kundenspezifischen Bestandteils (1) auf dem Teilgerät (7).

23. Gerät nach Anspruch 22, dadurch gekennzeichnet, dass das Teilgerät (7) eine Fehleranzeige aufweist, so dass nach der Montage des kundenspezifischen Bestandteils (1) und der Übernahme der gespeicherten kundenspezifischen Daten in das Teilgerät (7) im Gerät eine Fehlermeldung vorhanden ist bei Existenz einer Widersprüchlichkeit der kundenspezifischen Daten mit einer im Gerät vorhandenen Hard- und/oder Firmware.

24. Gerät nach einem der Ansprüche 21 bis 23, dadurch gekennzeichnet, dass eine Anordnung vorhanden ist zur Erzeugung sichtbarer kundenspezifischer Angaben auf das kundenspezifischen Bestandteil (1) mittels der im Speicher oder aufdem Informationsträger des kundenspezifischen Bestandteils (1) gespeicherten kundenspezifischen Daten.

25. Gerät nach einem der Ansprüche 21 bis 24, dadurch gekennzeichnet, dass der Speicher beziehungsweise der Informationsträger des kundenspezifischen Bestandteils (1) auf einer Rückseite (1a) oder Vorderseite des letzteren angeordnet ist.

26. Gerät nach einem der Ansprüche 21 bis 25, dadurch gekennzeichnet, dass der Speicher des kundenspezifischen Bestandteils in einem Chip (11) enthalten ist, der ein Teil einer Chip-Karte (12) ist.

27. Gerät nach einem der Ansprüche 1 bis 26, dadurch gekennzeichnet, dass das Gerät ein Elektrizitätszähler und/oder ein Tarifgerät und/oder ein Rundsteuerempfänger ist.

28. Gerät nach einem der Ansprüche 1 bis 27, dadurch gekennzeichnet, dass die kundenspezifischen Bestandteile (1, 2) zu den letzten, auf oder in das kundenneutrale Teilgerät (7) montierten Bestandteilen gehören.
